# EUROPÄISCHE PATENTSCHRIFT

(11) **EP 2 981 758 B1**
(45) Veröffentlichungstag und Bekanntmachung des Hinweises auf die Patenterteilung: **23.09.2020**
(21) Anmeldenummer: 14701784.2
(22) Anmeldetag: 30.01.2014
(51) Int. Cl.: F21K 99/00, F21V 23/06, F21V 23/00, F21V 19/00, F21V 15/01, H05K 3/32, F21V 17/10, F21Y 115/10, H05K 1/18, F21Y 105/10

(54) **OPTOELEKTRONISCHE BAUGRUPPE UND VERFAHREN ZUM HERSTELLEN EINER OPTOELEKTRONISCHEN BAUGRUPPE**
OPTOELECTRONIC ASSEMBLY AND METHOD FOR PRODUCING AN OPTOELECTRONIC ASSEMBLY
SOUS-ENSEMBLE OPTOÉLECTRONIQUE ET PROCÉDÉ DE FABRICATION D'UN SOUS-ENSEMBLE OPTOÉLECTRONIQUE

(30) Priorität: 04.04.2013 DE 102013205998
(43) Veröffentlichungstag der Anmeldung: 10.02.2016
(73) Patentinhaber: OSRAM GmbH, 80807 München (DE)
(72) Erfinder: PREUSCHL, Thomas, 93161 Sinzing (DE); SACHSENWEGER, Peter, 93197 Zeitlarn (DE)
(86) Internationale Anmeldenummer: PCT/EP2014/051843
(87) Internationale Veröffentlichungsnummer: WO 2014/161680

(56) Entgegenhaltungen:
- WO-A1-2012/055852
- WO-A1-2013/017984
- WO-A2-2012/148910
- US-A1- 2011 063 849
- US-A1- 2012 293 997

## Beschreibung

Die Erfindung betrifft eine optoelektronische Baugruppe und ein Verfahren zum Herstellen einer optoelektronischen Baugruppe

Bei einer herkömmlichen optoelektronischen Baugruppe wird ein optoelektronisches Bauelement auf einem Trägerelement angeordnet und elektrisch mit Kontaktstellen auf dem Trägerelement verbunden. Das Trägerelement und eine Leiterplatte werden auf einem Haltekörper angeordnet, beispielsweise darauf festgeklebt. Die Kontaktstellen des Trägers können mit Anschlussstellen der Leiterplatte verbunden werden, beispielsweise mittels isolierter Drähte, die an den Kontaktstellen und den Anschlussstellen festgelötet werden können. Ein Gehäuse, das beispielsweise in einem Spritzgussverfahren hergestellt werden kann, kann an der Leiterplatte und/oder dem Haltekörper befestigt werden. Die Befestigung kann beispielsweise mittels Klebens und/oder einer Steck- oder Rastverbindung erfolgen. Das Gehäuse dient beispielsweise als Schutz für elektronische Komponenten und/oder elektrische Kontaktierungen oder Anschlüsse der optoelektronischen Baugruppe gegen äußerliche Einwirkungen, wie beispielsweise Stöße und/oder Feuchtigkeit.

Nach Fertigstellung kann die optoelektronische Baugruppe dann ihrerseits an einem Montagekörper montiert werden, beispielsweise mittels Klipsen, Schrauben, Nieten oder Kleben. Beispielsweise zum Schrauben können Montageausnehmungen in der optoelektronischen Baugruppe vorgesehen sein, die sich durch das Gehäuse und die Leiterplatte hindurch erstrecken können. Insbesondere kann der Haltekörper thermisch mit einer Wärmesenke oder einem Wärmeverteiler gekoppelt werden, beispielsweise unter Verwendung eines thermisch gut leitenden Klebers.

Die optoelektronische Baugruppe kann beispielsweise dem Zhaga-Standard entsprechen. In dem Zhaga-Standard sind definierte Schnittstellen-Spezifikationen festlegt. Dies gewährleistet die Austauschbarkeit von LED-Lichtquellen verschiedener Hersteller.

Während des Betriebs der optoelektronischen Baugruppe entsteht Wärme, die beispielsweise über das Trägerelement und den Haltekörper hin zu der Wärmesenke bzw. dem Wärmeverteiler abgeführt werden kann. Dabei bilden grundsätzlich die Klebeverbindungen zwischen dem Trägerelement und dem Haltekörper und zwischen dem Haltekörper und der Wärmesenke bzw. dem Wärmeverteiler einen hohen thermischen Widerstand, der die Wärmeabfuhr nachteilig beeinträchtigt.

Ferner ist das Anlöten der isolierten Drähte an die Kontaktstellen und Anschlussstellen relativ aufwendig, beispielsweise zeitaufwendig und/oder kostenintensiv und die isolierten Drähte selbst können relativ teuer sein.

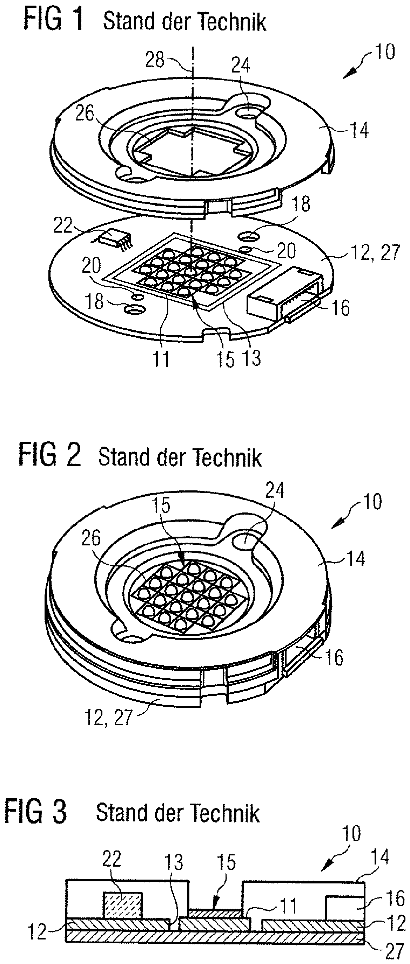

Die WO 2012/055852A1 zeigt ein Beispiel für optoelektronische Baugruppen nach dem Stand der Technik. Weiterhin werden derartige Baugruppen, wie in den Figuren 1 bis 3 dargestellt, beispielsweise unter der Bezeichnung PrevaLED Core ECO Z2 von der Firma OSRAM hergestellt. Die WO 2012/148910 A2 offenbart eine modular aufgebaute Leuchtdiodenlampe, wobei eine Leiterplatte mittels federnden Kontaktelementen mit einer mit Leuchtdioden versehenen Trägerplatte verbunden ist. Die US 2011/063849 A1 offenbart eine modular aufgebaute Leuchtdiodenlampe mit federnden Montage-Elementen.

In verschiedenen Ausführungsbeispielen wird eine optoelektronische Baugruppe bereitgestellt, die einfach und/oder kostengünstig herstellbar ist, beispielsweise indem ein optoelektronisches Bauelement der optoelektronischen Baugruppe einfach bzw. kostengünstig elektrisch kontaktierbar ist, und/oder die zu einem effektiven Betrieb von elektronischen und/oder optoelektronischen Bauelementen der optoelektronischen Baugruppe beiträgt, beispielsweise indem eine gute Wärmeabfuhr während des Betriebes gewährleistet ist.

In verschiedenen Ausführungsbeispielen wird ein Verfahren zum Herstellen einer optoelektronischen Baugruppe bereitgestellt, das einfach und/oder kostengünstig durchführbar ist, beispielsweise indem ein optoelektronisches Bauelement der optoelektronischen Baugruppe einfach bzw. kostengünstig elektrisch kontaktierbar ist, und/oder das dazu beiträgt, dass elektronische und/oder optoelektronische Bauelemente der optoelektronische Baugruppe effektiv betrieben werden können, beispielsweise indem eine gute Wärmeabfuhr während des Betriebes gewährleistet ist.

In verschiedenen Ausführungsbeispielen wird eine optoelektronische Baugruppe bereitgestellt. Eine Leiterplatte der optoelektronischen Baugruppe weist eine erste Seite der Leiterplatte, eine von der ersten Seite abgewandte zweite Seite der Leiterplatte, eine zentrale Ausnehmung der Leiterplatte, mindestens eine Kontaktausnehmung und auf der ersten Seite der Leiterplatte mindestens eine Anschlussstelle auf. Ein Trägerelement der optoelektronischen Baugruppe ist mit der Leiterplatte körperlich gekoppelt, weist eine erste Seite des Trägerelements auf, die der zweiten Seite der Leiterplatte zugewandt ist, und weist auf der ersten Seite des Trägerelements mindestens eine Kontaktstelle auf. Die Kontaktstelle des Trägerelements ist in der Kontaktausnehmung der Leiterplatte freigelegt. Mindestens ein optoelektronisches Bauelement der optoelektronischen Baugruppe ist über das Trägerelement mit der Kontaktstelle elektrisch gekoppelt und ist so auf der ersten Seite des Trägerelements angeordnet, dass es in der zentralen Ausnehmung der Leiterplatte freigelegt ist. Ein Gehäusekörper der optoelektronischen Baugruppe weist eine zentrale Ausnehmung auf und ist so ausgebildet und so mit der Leiterplatte körperlich gekoppelt, dass das optoelektronische Bauelement in der zentralen Ausnehmung des Gehäusekörpers freigelegt ist. Mindestens ein Kontaktelement der optoelektronischen Baugruppe ist an einer Innenseite des Gehäusekörpers angeordnet und so ausgebildet, dass das Kontaktelement die Kontaktstelle des Trägerelements mit der Anschlussstelle der Leiterplatte elektrisch koppelt.

Die in der Kontaktausnehmung freigelegte Kontaktstelle des Trägerelements und die Verbindung der Kontaktstelle des Trägerelements mit der Anschlussstelle der Leiterplatte über das Kontaktelement tragen zu einem einfachen und schnellen elektrischen Kontaktieren des optoelektronischen Bauelements und damit zu einem einfachen und kostengünstigen Herstellen der optoelektronischen Baugruppe bei. Das Befestigen des Trägerelements direkt an der Leiterplatte ermöglicht, auf den Haltekörper zu verzichten, wodurch ein Arbeitsschritt entfällt und Materialaufwand gespart werden kann. Darüber hinaus kann zwischen dem Trägerelement und einer Wärmesenke und/oder einem Wärmeverteiler, an der bzw. dem die optoelektronische Baugruppe befestigt werden kann, lediglich eine Klebstoffschicht ausgebildet werden, wodurch lediglich ein thermischer Widerstand gebildet ist, da auf den Haltekörper und die damit verbundene weitere Klebstoffschicht zwischen dem Trägerelement und der Wärmesenke bzw. dem Wärmeverteiler verzichtet werden kann. Dies trägt dazu bei, dass bei dem Betrieb der optoelektronischen Baugruppe entstehende Wärme schnell von dem optoelektronischen Bauelement abführbar ist, was zu einem effektiven Betreiben der optoelektronischen Baugruppe beiträgt.

Zusätzlich zu der mindestens einen Kontaktstelle können beispielsweise eine, zwei oder mehr weitere Kontaktstellen auf dem Trägerelement ausgebildet sein. Dementsprechend können zwei oder mehr Kontaktausnehmungen in der Leiterplatte, Anschlussstellen auf der Leiterplatte und entsprechende Kontaktelemente ausgebildet und angeordnet sein.

Das bzw. die Kontaktelemente können beispielsweise ein Metall aufweisen oder daraus gebildet sein. Beispielsweise können die Kontaktelemente eine korrosionsbeständige Legierung aufweisen.

Bei verschiedenen Ausführungsbeispielen weist das Kontaktelement einen mittleren Abschnitt, über den das Kontaktelement an dem Gehäusekörper befestigt ist, einen zweiten Endabschnitt, der von dem Gehäusekörper absteht und der mit der Anschlussstelle gekoppelt ist, und einen ersten Endabschnitt auf, der von dem Gehäusekörper absteht und der mit der Kontaktstelle gekoppelt ist. Beispielsweise weist das Kontaktelement eine U-Form mit runden oder eckigen Übergängen und/oder eine Bogenform auf. Beispielsweise ist das Kontaktelement von dem Gehäusekörper aus gesehen konkav ausgebildet. Dies kann dazu beitragen, das Kontaktelement einfach und sicher an dem Gehäuse befestigen zu können und/oder die Anschlussstelle der Leiterplatte und die Kontaktstelle des Trägerelements einfach und sicher kontaktieren zu können.

Bei verschiedenen Ausführungsbeispielen ist das Kontaktelement als Federelement ausgebildet. Beispielsweise ist das Kontaktelement so ausgebildet, dass es bei nicht auf der Leiterplatte angeordnetem Gehäusekörper an seinen Endabschnitten weiter von der Innenseite des Gehäusekörpers absteht als bei auf der Leiterplatte angeordnetem Gehäusekörper eine lichte Weite zwischen der Innenseite des Gehäusekörpers und der Anschlussstelle bzw. der Kontaktstelle groß ist. Dies bewirkt, dass das Kontaktelement beim Anordnen des Gehäusekörpers auf der Leiterplatte elastisch verformt wird und bei der fertiggestellten optoelektronischen Baugruppe unter mechanischer Spannung steht. Dies bewirkt, dass die Endabschnitte des Kontaktelements mit einer moderaten Kraft gegen die Anschlussstelle der Leiterplatte bzw. die Kontaktstelle des Trägerelements gedrückt werden, wodurch eine gute und sichere elektrische Kopplung der Anschlussstelle mit der Kontaktstelle gesichert ist, auch wenn sich das optoelektronische Bauelement, beispielsweise der Gehäusekörper und/oder die Leiterplatte, während des Betriebs aufgrund unterschiedlicher thermischer Ausdehnungskoeffizienten der verwendeten Materialien und/oder mit zunehmender Betriebsdauer verformt.

Bei verschiedenen Ausführungsbeispielen weist der Gehäusekörper an seiner Innenseite mindestens einen Haltestift auf und das Kontaktelement weist eine Halteausnehmung des Kontaktelements auf. Der Haltestift ragt durch die Halteausnehmung des Kontaktelements. Der Haltestift und die Halteausnehmung können dazu beitragen, das Kontaktelement auf einfache Weise an dem Gehäusekörper zu befestigen. Insbesondere kann mittels der Haltestifte eine geeignete Positionierung, Orientierung und/oder Ausrichtung des Kontaktelements zu dem Gehäusekörper und somit nachfolgend zu der Anschlussstelle und der Kontaktstelle sichergestellt werden. Alternativ oder zusätzlich kann das Kontaktelement an dem Gehäusekörper festgeklebt werden. Ferner können zusätzlich zu dem Haltestift ein, zwei oder mehr weitere Haltestifte an der Innenseite des Gehäusekörpers ausgebildet sein. Dementsprechend können zwei oder mehr weitere Halteausnehmungen in dem Kontaktelement ausgebildet sein.

Bei verschiedenen Ausführungsbeispielen weist die Leiterplatte eine Halteausnehmung der Leiterplatte auf. Der Haltestift ragt durch die Halteausnehmung der Leiterplatte. Dies kann dazu beitragen, den Gehäusekörper auf einfache Weise an der Leiterplatte zu befestigen. Falls zwei oder mehr Haltestifte an der Innenseite des Gehäusekörpers ausgebildet sind, können auch zwei oder mehr entsprechende Halteausnehmungen der Leiterplatte ausgebildet sein.

Bei verschiedenen Ausführungsbeispielen ist der Teil des Haltestifts, der durch die Halteausnehmung des Kontaktelements ragt, mit einer Übermaßpassung zu der Halteausnehmung des Kontaktelements ausgebildet. Alternativ oder zusätzlich ist der Teil des Haltestifts, der durch die Halteausnehmung der Leiterplatte ragt, mit einer Übermaßpassung zu der Halteausnehmung der Leiterplatte ausgebildet. Beispielweise kann der durch die entsprechende Halteausnehmung hindurch ragende Teil des Haltestifts derart dauerhaft verformt werden, dass die Übermaßpassung gegeben ist. Beispielsweise kann der entsprechende Teil des Haltestifts unter thermischer Einwirkung verformt werden, beispielsweis mittels Heißprägens (Hotstamp).

Bei verschiedenen Ausführungsbeispielen ragt der Haltestift so weit durch die Halteausnehmung der Leiterplatte, dass ein Endabschnitt des Haltestifts mit einer zweiten Seite des Trägerelements, die von der ersten Seite des Trägerelements abgewandt ist, bündig ist. Dies bewirkt, dass bei einem Anordnen der optoelektronischen Baugruppe auf einem weiteren Körper, beispielsweise der Wärmesenke oder dem Wärmeverteiler, der Haltestift und die zweite Seite des Trägerelements in Kontakt mit dem entsprechenden Körper sind. Dies kann dazu beitragen, ein Verbiegen der optoelektronischen Baugruppe beim Verbinden der optoelektronischen Baugruppe mit dem entsprechenden Körper gering zu halten oder zu verhindern.

Bei verschiedenen Ausführungsbeispielen weist der Gehäusekörper mindestens eine Montageausnehmung des Gehäusekörpers auf, die so ausgebildet ist, dass eine Wandung der Montageausnehmung des Gehäusekörpers durch eine Montageausnehmung der Leiterplatte ragt. Dies kann dazu beitragen, den Gehäusekörper mit der Leiterplatte zu verbinden. Ferner kann dies dazu beitragen, dass der Gehäusekörper relativ zu der Leiterplatte bestimmungsgemäß ausgerichtet, orientiert und/oder positioniert ist.

Bei verschiedenen Ausführungsbeispielen ragt die Wandung so weit durch die Montageausnehmung der Leiterplatte, dass ein Endabschnitt der Wandung mit einer zweiten Seite des Trägerelements, die von der ersten Seite des Trägerelements abgewandt ist, bündig ist. Dies bewirkt, dass bei einem Anordnen der optoelektronischen Baugruppe auf dem weiteren Körper, beispielsweise der Wärmesenke oder dem Wärmeverteiler, die Wandung und die zweite Seite des Trägerelements in Kontakt mit dem entsprechenden Körper sind. Dies kann dazu beitragen, ein Verbiegen der optoelektronischen Baugruppe beim Verbinden der optoelektronischen Baugruppe mit dem entsprechenden Körper gering zu halten oder zu verhindern.

Bei verschiedenen Ausführungsbeispielen sind an einer Außenseite der Wandung Montagerippen ausgebildet, wobei die Außenseite der Wandung zwischen den Montagerippen mit einer Spielpassung zu der Montageausnehmung der Leiterplatte ausgebildet ist und die Montagerippen gemäß einer Übermaßpassung zu der Montageausnehmung der Leiterplatte ausgebildet sind. Die Spielpassung der Wandung zu der Montageausnehmung der Leiterplatte bewirkt, dass die Wandung einfach in die Montageausnehmung der Leiterplatte einführbar ist. Die Übermaßpassung der Montagerippen zu der Montageausnehmung der Leiterplatte bewirkt, dass zwischen der Wandung und der Montageausnehmung der Leiterplatte über die Montagerippen eine kraftschlüssige Verbindung, beispielsweise mittels einer Presspassung, besteht. Dies kann dazu beitragen, den Gehäusekörper auf einfache Weise fest mit der Leiterplatte zu verbinden.

Bei verschiedenen Ausführungsbeispielen weist der Gehäusekörper an seiner Innenseite mindestens einen Befestigungsstift auf, der so ausgebildet ist, dass er durch eine Befestigungsausnehmung der Leiterplatte ragt. Der Befestigungsstift kann alternativ oder zusätzlich zu der Montageausnehmung des Gehäusekörpers ausgebildet sein und dementsprechend alternativ oder zusätzlich zu der Montageausnehmung des Gehäusekörpers dazu beitragen, dass der Gehäusekörper auf einfache Weise und/oder richtig orientiert, richtig positioniert und/oder richtig ausgerichtet mit der Leiterplatte verbunden werden kann.

Bei verschiedenen Ausführungsbeispielen ragt der Befestigungsstift so weit durch die Befestigungsausnehmung der Leiterplatte, dass ein Endabschnitt des Befestigungsstifts mit einer zweiten Seite des Trägerelements, die von der ersten Seite des Trägerelements abgewandt ist, bündig ist. Dies bewirkt, dass bei einem Anordnen der optoelektronischen Baugruppe auf dem weiteren Körper, beispielsweise der Wärmesenke oder dem Wärmeverteiler, der Befestigungsstift und die zweite Seite des Trägerelements in Kontakt mit dem entsprechenden Körper sind. Dies kann dazu beitragen, ein Verbiegen der optoelektronischen Baugruppe beim Verbinden der optoelektronischen Baugruppe mit dem entsprechenden Körper gering zu halten oder zu verhindern.

Bei verschiedenen Ausführungsbeispielen mündet die Kontaktausnehmung in die zentrale Ausnehmung der Leiterplatte. In anderen Worten können die Kontaktausnehmung und die zentrale Ausnehmung der Leiterplatte einstückig ausgebildet sein. In wieder anderen Worten kann eine Ausnehmung der Leiterplatte ausgebildet sein, die die Kontaktausnehmung und die zentrale Ausnehmung umfasst. In wieder anderen Worten können die Kontaktstelle und das optoelektronische Bauelement in einer gemeinsamen Ausnehmung der Leiterplatte freigelegt sein.

In verschiedenen Ausführungsbeispielen wird ein Verfahren zum Herstellen einer optoelektronischen Baugruppe bereitgestellt, bei dem ein Trägerelement bereitgestellt wird, das eine erste Seite des Trägerelements und auf der ersten Seite des Trägerelements mindestens eine Kontaktstelle aufweist. Mindestens ein optoelektronisches Bauelement wird auf der ersten Seite des Trägerelements angeordnet und über das Trägerelement mit den beiden Kontaktstellen des Trägerelements elektrisch gekoppelt wird. Eine Leiterplatte wird bereitgestellt, die eine erste Seite der Leiterplatte, eine von der ersten Seite der Leiterplatte abgewandte zweite Seite der Leiterplatte, eine zentrale Ausnehmung, mindestens eine Kontaktausnehmung, und auf der ersten Seite der Leiterplatte mindestens eine Anschlussstelle aufweist. Das Trägerelement wird so mit der Leiterplatte körperlich gekoppelt, dass die erste Seite des Trägerelements der zweiten Seite der Leiterplatte zugewandt ist, dass das optoelektronische Bauelement in der zentralen Ausnehmung der Leiterplatte freigelegt ist und dass die Kontaktstelle des Trägerelements in der Kontaktausnehmung der Leiterplatte freigelegt ist. Ein Gehäusekörper wird bereitgestellt, der eine zentrale Ausnehmung aufweist und an dessen Innenseite mindestens ein elektrisch leitfähiges Kontaktelement angeordnet ist. Der Gehäusekörper wird so mit der Leiterplatte körperlich gekoppelt, dass das optoelektronische Bauelement in der zentralen Ausnehmung des Gehäusekörpers freigelegt ist und dass das Kontaktelement die Kontaktstelle des Trägerelements mit der Anschlussstelle der Leiterplatte elektrisch koppelt.

Dass das Trägerelement bereitgestellt wird, kann beispielsweise bedeuten, dass das Trägerelement als fertiges Bauelement angeordnet wird oder dass das Trägerelement ausgebildet wird. Dass die Leiterplatte bereitgestellt wird, kann beispielsweise bedeuten, dass die Leiterplatte als fertiges Bauelement angeordnet wird oder dass die Leiterplatte ausgebildet wird. Dass der Gehäusekörper bereitgestellt wird, kann beispielsweise bedeuten, dass der Gehäusekörper als fertiges Bauelement angeordnet wird oder dass der Gehäusekörper ausgebildet wird.

Bei verschiedenen Ausführungsbeispielen wird das Kontaktelement mittels eines Haltestifts des Gehäusekörpers und einer dazu korrespondierenden Halteausnehmung des Kontaktelements an dem Gehäusekörper befestigt. Optional kann ein aus der Halteausnehmung des Kontaktelements heraus ragender Teil des Haltestifts dauerhaft verformt werden, beispielsweise mittels Heißprägens, wodurch beispielsweise eine Übermaßpassung zu der Halteausnehmung des Kontaktelements und damit eine nicht ohne Zerstörung lösbare Verbindung zwischen dem Kontaktelement und dem Gehäusekörper erzeugt werden kann.

Ausführungsbeispiele der Erfindung sind in den Figuren dargestellt und werden im Folgenden näher erläutert.

Es zeigen:
- Figur 1: eine Explosionsdarstellung einer optoelektronischen Baugruppe gemäß dem Stand der Technik;
- Figur 2: eine perspektivische Ansicht der in Figur 1 gezeigten optoelektronische Baugruppe gemäß dem Stand der Technik;
- Figur 3: einen Querschnitt durch die in Figur 1 gezeigte optoelektronische Baugruppe gemäß dem Stand der Technik;
- Figur 4: eine Explosionsdarstellung eines Ausführungsbeispiels einer Leiterplatte, eines Trägerelements und eines optoelektronischen Bauelements;
- Figur 5: eine perspektivische Ansicht eines Ausführungsbeispiels einer Leiterplatte, eines Trägerelements und eines optoelektronischen Bauelements;
- Figur 6: eine perspektivische Ansicht eines Ausführungsbeispiels einer Innenseite eines Gehäusekörpers;
- Figur 7: eine perspektivische Ansicht eines Ausführungsbeispiels eines Kontaktelements;
- Figur 8: eine perspektivische Ansicht einer Unterseite eines Ausführungsbeispiels einer optoelektronischen Baugruppe;
- Figur 9: eine Schnittdarstellung durch ein Ausführungsbeispiel einer optoelektronischen Baugruppe;

- Figur 10: eine Schnittdarstellung durch ein Ausführungsbeispiel einer optoelektronischen Baugruppe;
- Figur 11: eine perspektivische Ansicht eines Ausführungsbeispiels einer Innenseite eines Gehäusekörpers und einer Leiterplatte, eines Trägerelements und eines optoelektronischen Bauelements;
- Figur 12: eine perspektivische Ansicht eines Ausführungsbeispiels einer Innenseite eines Gehäusekörpers und einer Leiterplatte, eines Trägerelements und eines optoelektronischen Bauelements.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Eine optoelektronische Baugruppe kann ein, zwei oder mehr optoelektronische Bauelemente und eine Leiterplatte und/oder einen Träger auf aufweisen, auf dem das optoelektronische Bauelement angeordnet ist und/oder mit dem das optoelektronische Bauelement elektrisch gekoppelt ist. Optional kann eine optoelektronische Baugruppe auch ein, zwei oder mehr elektronische Bauelemente aufweisen. Ein elektronisches Bauelement kann beispielsweise ein aktives und/oder ein passives Bauelement aufweisen. Ein aktives elektronisches Bauelement kann beispielsweise eine Rechen-, Steuer- und/oder Regeleinheit und/oder einen Transistor aufweisen. Ein passives elektronisches Bauelement kann beispielsweise einen Kondensator, einen Widerstand, eine Diode oder eine Spule aufweisen.

Ein optoelektronisches Bauelement kann in verschiedenen Ausführungsbeispielen ein elektromagnetische Strahlung emittierendes Bauelement oder ein elektromagnetische Strahlung absorbierendes Bauelement sein. Ein elektromagnetische Strahlung absorbierendes Bauelement kann beispielsweise eine Solarzelle sein. Ein elektromagnetische Strahlung emittierendes Bauelement kann in verschiedenen Ausführungsbeispielen ein elektromagnetische Strahlung emittierendes Halbleiter-Bauelement sein und/oder als eine elektromagnetische Strahlung emittierende Diode, als eine organische elektromagnetische Strahlung emittierende Diode, als ein elektromagnetische Strahlung emittierender Transistor oder als ein organischer elektromagnetische Strahlung emittierender Transistor ausgebildet sein. Die Strahlung kann beispielsweise Licht im sichtbaren Bereich, UV-Licht und/oder Infrarot-Licht sein. In diesem Zusammenhang kann das elektromagnetische Strahlung emittierende Bauelement beispielsweise als Licht emittierende Diode (light emitting diode, LED) als organische Licht emittierende Diode (organic light emitting diode, OLED), als Licht emittierender Transistor oder als organischer Licht emittierender Transistor ausgebildet sein. Das Licht emittierende Bauelement kann in verschiedenen Ausführungsbeispielen Teil einer integrierten Schaltung sein. Weiterhin kann eine Mehrzahl von Licht emittierenden Bauelementen vorgesehen sein, beispielsweise untergebracht in einem gemeinsamen Gehäuse.

Die Verbindung eines ersten Körpers mit einem zweiten Körper kann formschlüssig, kraftschlüssig und/oder stoffschlüssig sein. Die Verbindungen können lösbar ausgebildet sein, d.h. reversibel. In verschiedenen Ausgestaltungen kann eine reversible, schlüssige Verbindung beispielsweise als eine Schraubverbindung, eine Klemmung, eine Rastverbindung und/oder mittels Klammern und/oder Haltestiften realisiert sein. Die Verbindungen können jedoch auch nicht lösbar ausgebildet sein, d.h. irreversibel. Eine nicht lösbare Verbindung kann dabei nur mittels Zerstörens der Verbindungsmittel getrennt werden. In verschiedenen Ausgestaltungen kann eine irreversible, schlüssige Verbindung beispielsweise als eine Nietverbindung, eine Klebeverbindung oder eine Lötverbindung realisiert sein.

Bei einer formschlüssigen Verbindung kann die Bewegung des ersten Körpers von einer Fläche des zweiten Körpers beschränkt werden, wobei sich der erste Körper senkrecht, d.h. normal, in Richtung der beschränkenden Fläche des zweiten Körpers bewegt. In anderen Worten wird bei einer formschlüssigen Verbindung eine Relativbewegung der beiden Körper aufgrund ihrer zueinander korrespondierenden Form in zumindest einer Richtung unterbunden. Ein Haken in einer Öse kann beispielsweise in mindestens einer Raumrichtung in der Bewegung beschränkt sein. In verschiedenen Ausgestaltungen kann eine formschlüssige Verbindung beispielsweise als eine Schraubverbindung, ein Klettverschluss, eine Klemmung, eine Rastverbindung und/oder mittels Klammern realisiert sein. Ferner kann eine formschlüssige Verbindung mittels einer Übermaßpassung eines ersten Körpers zu einem zweiten Körper ausgebildet sein. Beispielsweise kann ein Endabschnitt eines Haltestifts, der durch eine Halteausnehmung geführt ist, derart verformt sein, dass sein Querschnitt größer ist als die Halteausnehmung und er nicht mehr zurück durch die Halteausnehmung geführt werden kann.

Bei einer kraftschlüssigen Verbindung kann aufgrund eines körperlichen Kontakts der beiden Körper unter Druck, eine Haftreibung eine Bewegung des ersten Körpers parallel zu dem zweiten Körper beschränken. Ein Beispiel für eine kraftschlüssige Verbindung kann beispielsweise ein Flaschenkorken in einem Flaschenhals oder ein Dübel mit einer Übermaßpassung in einem entsprechenden Dübelloch sein. Ferner kann die kraftschlüssige Verbindung mittels einer Presspassung zwischen einem ersten Körper und einem zweiten Körper ausgebildet sein. Beispielsweise kann ein Durchmesser des Haltestifts so gewählt werden, dass er gerade noch unter Verformung des Haltestifts und/oder der entsprechenden Halteausnehmung in die Halteausnehmung einführbar ist, jedoch nur noch unter erhöhtem Kraftaufwand wieder aus dieser entfernbar ist.

Bei einer stoffschlüssigen Verbindung kann der erste Körper mit dem zweiten Körper mittels atomarer und/oder molekularer Kräfte verbunden sein. Stoffschlüssige Verbindungen können häufig nicht lösbare Verbindungen sein. In verschiedenen Ausgestaltungen kann eine stoffschlüssige Verbindung beispielsweise als eine Klebeverbindung, eine Lotverbindung, beispielsweise eines Glaslotes oder eines Metalotes, oder als eine Schweißverbindung realisiert sein.

Bei einer Spielpassung weist ein Körper, der in eine Ausnehmung eingeführt wird geringere Außenmaße auf als die Ausnehmung Innenmaße. In anderen Worten besteht zwischen einer Wandung der Ausnehmung und dem darin angeordneten Körper zumindest ein geringer Spalt. Der Körper ist somit einfach in die Ausnehmung einführbar und/oder aus ihr entnehmbar. Bei einer Übermaßpassung weist ein Körper, der in eine Ausnehmung eingeführt wird größere Außenmaße auf als die Ausnehmung Innenmaße. Der Körper ist somit nur mit erhöhtem Aufwand in die Ausnehmung einführbar und/oder aus ihr entnehmbar. Der erhöhte Aufwand kann beispielsweise sein, dass der Körper und/oder die Ausnehmung verformt werden, dass viel Kraft aufgewendet werden muss und/oder dass der Körper abgekühlt werden muss, damit er in die Ausnehmung passt. Die Übermaßpassung kann auch als Presspassung bezeichnet werden.

**Fig.1** zeigt eine optoelektronische Baugruppe 10 gemäß dem Stand der Technik in Explosionsdarstellung. Die optoelektronische Baugruppe 10 gemäß dem Stand der Technik kann beispielsweise dem Zhaga-Standard entsprechen. Die optoelektronische Baugruppe 10 gemäß dem Stand der Technik weist eine Leiterplatte 12 und ein Trägerelement 11 auf einem Haltekörper 27, ein optoelektronisches Bauelement 15 auf dem Trägerelement 11 und einen Gehäusekörper 14 auf.

Eine erste Seite der Leiterplatte 12 ist dem Gehäusekörper 14 zugewandt. Eine von der ersten Seite abgewandte zweite Seite der Leiterplatte 12 ist einer ersten Seite des Haltekörpers 27 zugewandt. Die Leiterplatte 12 kann beispielsweise mittels einer stoffschlüssigen Verbindung an dem Haltekörper 27 befestigt sein. Beispielsweise kann die Leiterplatte 12 mittels einer Klebeverbindung an dem Haltekörper 27 befestigt sein, das Material der Leiterplatte 12 kann direkt auf dem Haltekörper 27 ausgebildet sein und/oder die Leiterplatte 12 kann auf den Haltekörper 27 auflaminiert sein. Die Leiterplatte 12 weist nicht gezeigte elektrisch leitfähige Leiterbahnen auf, die beispielsweise zumindest teilweise auf der ersten Seite der Leiterplatte 12 ausgebildet sein können. Die Leiterplatte 12 weist weiter in Figur 1 nicht gezeigte Anschlussstellen auf, die mit den Leiterbahnen elektrisch gekoppelt sind. Die Leiterplatte 12 weist eine zentrale Ausnehmung 13 der Leiterplatte 12 auf.

In der zentralen Ausnehmung 13 der Leiterplatte 12 und auf dem Haltekörper 27 ist das Trägerelement 11 angeordnet. Das Trägerelement 11 weist eine erste Seite des Trägerelements 11 und eine von der ersten Seite des Trägerelements 11 abgewandte zweite Seite des Trägerelements 11 auf. Die zweite Seite des Trägerelements 11 kann beispielsweise dem Haltekörper 27 zugewandt sein. Das Trägerelement 11 kann beispielsweise mittels einer stoffschlüssigen Verbindung, beispielsweise einer Klebeverbindung, an dem Trägerelement 11 befestigt sein.

Auf der ersten Seite der Leiterplatte 12 ist ein Steckerelement 16 angeordnet. Das Steckerelement 16 weist einen Steckerkörper und elektrisch leitfähige Steckkontakte auf, die beispielsweise teilweise in dem Steckerkörper angeordnet sind und die elektrisch mit den Leiterbahnen gekoppelt sind.

Auf dem Trägerelement 11 ist das optoelektronische Bauelement 15 angeordnet. Beispielsweise ist eine Mehrzahl von optoelektronischen Bauelementen 15 auf dem Trägerelement 11 angeordnet. Das optoelektronische Bauelement 15 ist mit in Figur 1 nicht gezeigten Kontaktstellen des Trägerelements 11 elektrisch gekoppelt. Die Kontaktstellen des Trägerelements 11 können beispielsweise mittels eines, zwei oder mehr isolierter Kabel mit den Leiterbahnen der Leiterplatte 12 elektrisch gekoppelt sein. Beispielsweise können optoelektronische Bauelemente 15 angeordnet sein, die Licht unterschiedlicher Farbe emittieren. Beispielsweise können die optoelektronischen Bauelemente 15 rotes, grünes, blaues und/oder weißes Licht emittieren.

Ferner können das bzw. die optoelektronischen Bauelemente 15 zumindest teilweise Konversionselemente zum Konvertieren der Wellenlängen der erzeugten elektromagnetischen Strahlung aufweisen. Beispielsweise können die optoelektronischen Bauelemente 15 mit einer Schicht bedeckt sein, die einen oder mehrere Leuchtstoffe als Konvertermaterial aufweist. Beispielsweise können die optoelektronischen Bauelemente 15 mit einer Leuchtstoff aufweisenden Silikonschicht bedeckt sein. Die Leuchtstoffe eignen sich zum Konvertieren von Licht bezüglich seiner Wellenlänge. Die Leuchtstoffe werden mit Hilfe der in dem optoelektronischen Bauelement 15 erzeugten elektromagnetischen Strahlung, die in diesem Zusammenhang auch als Anregungslicht bezeichnet werden kann, energetisch angeregt. Beim nachfolgenden energetischen Abregen emittieren die Leuchtstoffe Licht einer oder mehrerer vorgegebener Farben. Es findet somit eine Konversion der Anregungsstrahlung statt, wodurch Konversionsstrahlung erzeugt wird. Bei der Konversion werden die Wellenlängen der Anregungsstrahlung zu kürzeren oder längeren Wellenlängen verschoben. Die Farben können Einzelfarben oder Mischfarben sein. Die Einzelfarben können beispielsweise grünes, rotes oder gelbes Licht aufweisen und/oder die Mischfarben können beispielsweise aus grünem, rotem und/oder gelbem Licht gemischt sein und/oder beispielsweise weißes Licht aufweisen. Beispielsweise können Grün, Rot und Gelb mit Hilfe von blauem Anregungslicht dargestellt werden. Zusätzlich kann blaues Licht bereitgestellt werden, beispielsweise indem die Schicht so ausgebildet wird, dass zumindest teilweise nicht konvertierte Anregungsstrahlung die Schicht als nutzbares Beleuchtungslicht verlässt. Bei Verwendung von UV-Anregungslicht können die Leuchtstoffe auch so gewählt werden, dass sie Rot, Grün, Blau und Gelb darstellen.

Übliche Leuchtstoffe sind beispielsweise Granate oder Nitride Silikate, Nitride, Oxide, Phosphate, Borate, Oxynitride, Sulfide, Selenide, Aluminate, Wolframate, und Halide von Aluminium, Silizium, Magnesium, Calcium, Barium, Strontium, Zink, Cadmium, Mangan, Indium, Wolfram und anderen Übergangsmetallen, oder Seltenerdmetallen wie Yttrium, Gadolinium oder Lanthan, die mit einem Aktivator, wie zum Beispiel Kupfer, Silber, Aluminium, Mangan, Zink, Zinn, Blei, Cer, Terbium, Titan, Antimon oder Europium dotiert sind. In verschiedenen Ausführungsformen ist der Leuchtstoff ein oxidischer oder (oxi-)nitridischer Leuchtstoff, wie ein Granat, Orthosilikat, Nitrido(alumo)silikat, Nitrid oder Nitridoorthosilikat, oder ein Halogenid oder Halophosphat. Konkrete Beispiele für geeignete Leuchtstoffe sind Strontiumchloroapatit:Eu ((Sr,Ca)5(PO4)3Cl:Eu; SCAP), Yttrium-Aluminium-Granat:Cer (YAG:Ce) oder CaAlSiN3:Eu. Ferner können im Leuchtstoff bzw. Leuchtstoffgemisch beispielsweise Partikel mit Licht streuenden Eigenschaften und/oder Hilfsstoffe enthalten sein. Beispiele für Hilfsstoffe schließen Tenside und organische Lösungsmittel ein. Beispiele für Licht streuende Partikel sind Gold-, Silber- und Metalloxidpartikel.

Auf der ersten Seite der Leiterplatte 12 können ein, zwei oder mehr elektronische Bauelemente 22 angeordnet sein. Das elektronische Bauelement 22 kann beispielsweise ein aktives oder ein passives Bauelement sein. Das aktive Bauelement kann beispielsweise eine Steuer- und/oder Regeleinheit sein. Das passive Bauelement kann beispielsweise ein Thermoelement, ein Widerstand, ein Kondensator oder eine Spule sein. Das elektronische Bauelement 22 kann beispielsweise mittels einer nicht lösbaren Verbindung, beispielsweise mittels einer Lötverbindung und/oder mittels Drahtbondens mit den Leiterbahnen der Leiterplatte 12 elektrisch gekoppelt sein.

Die Leiterplatte 12 kann Montageausnehmungen 18 der Leiterplatte 12 aufweisen, die zum Befestigen des optoelektronischen Bauelements 10 an einer nicht dargestellten Montagefläche, beispielsweise einer Wärmesenke oder einem Wärmeverteiler, dienen können. Ferner kann die Leiterplatte 12 beispielsweise Befestigungsausnehmungen 20 aufweisen, die beispielsweise dazu dienen können, in Figur 1 nicht dargestellte Befestigungsstifte des Gehäusekörpers 14 aufzunehmen, mittels derer der Gehäusekörper 14 beispielsweise einfach relativ zu der Leiterplatte 12 ausgerichtet und/oder an dieser festgelegt werden kann. Beispielsweise können die Befestigungsstifte in den entsprechenden Verbindungsausnehmungen 20 mittels einer Presspassung kraftschlüssig festgelegt werden.

Ferner kann der Gehäusekörper 14 beispielsweise Montageausnehmungen 24 des Gehäusekörpers 14 aufweisen, die beispielsweise bei bestimmungsgemäßer Anordnung des Gehäusekörpers 14 auf der Leiterplatte 12 konzentrisch die Montageausnehmungen 18 der Leiterplatte 12 überlappen, so dass sie gemeinsame Montageausnehmungen des optoelektronischen Bauelements 10 bilden. Diese gemeinsamen Montageausnehmungen können genutzt werden, um das optoelektronische Bauelement 10 an der Montagefläche zu befestigen, beispielsweise mittels eines lösbaren Befestigungsmittels, beispielsweise mittels einer Schraubverbindung. Die Montageausnehmungen 24 des Gehäusekörpers 14 können beispielsweise mit Hilfe von nicht dargestellten Hülsen, die beispielsweise eng am Innenumfang der Montageausnehmungen 24 des Gehäusekörpers 14 anliegen, verstärkt werden.

Der Gehäusekörper 14 weist weiter eine zentrale Ausnehmung 26 des Gehäusekörpers 14 auf, in der bei bestimmungsgemäß auf der Leiterplatte 12 angeordnetem Gehäusekörper 14 das optoelektronische Bauelement 15 freigelegt ist. Die optoelektronische Baugruppe 10 kann beispielsweise bzgl. ihrer äußeren Form weitgehend rotationssymmetrisch, beispielsweise rundlich, beispielsweise kreisförmig ausgebildet sein, beispielsweise rotationssymmetrisch um eine Symmetrieachse 28. Alternativ dazu kann in die äußere Form des optoelektronischen Bauelements 10 jedoch auch anders ausgebildet sein, beispielsweise eckig, beispielsweise viereckig, beispielsweise rechteckig, beispielsweise quadratisch.

**Fig. 2** zeigt die in Figur 1 gezeigte optoelektronische Baugruppe 10 gemäß dem Stand der Technik mit bestimmungsgemäß auf der Leiterplatte 12 angeordnetem Gehäusekörper 14.

**Fig. 3** zeigt eine Schnittdarstellung des in Figur 2 gezeigten optoelektronischen Bauelements 10 gemäß dem Stand der Technik. Die Leiterplatte 12 und das Trägerelement 11 sind auf dem Haltekörper 27 angeordnet. Die Leiterplatte 12, beispielsweise die erste Seite der Leiterplatte 12, kann beispielsweise zum mechanischen Aufnehmen und/oder elektrischen Kontaktieren des elektronischen Bauelements 22 und/oder des Steckerelements 16 dienen. Ferner kann die Leiterplatte 12 beispielsweise zum elektrischen Kontaktieren des optoelektronischen Bauelements 15 dienen. Der Haltekörper 27 kann beispielsweise zum Aufnehmen der Leiterplatte 12 und/oder des Trägerelements 11 dienen, wobei die von der ersten Seite der Leiterplatte 12 abgewandte zweite Seite der Leiterplatte 12 dem Haltekörper 27 zugewandt und/oder mit diesem körperlich gekoppelt ist. Ferner kann der Haltekörper 27 beispielsweise zum mechanischen Stabilisieren des optoelektronischen Bauelements 10 beitragen. Ferner kann der Haltekörper 27 als Wärmesenke für das optoelektronische Bauelement 15 dienen. Zusätzlich kann die optoelektronische Baugruppe 10 an einer nicht dargestellten Wärmesenke oder einem nicht dargestellten Wärmeverteiler angeordnet sein.

Das Steckerelement 16, beispielsweise die Steckerkontakte des Steckerelements 16, das optoelektronische Bauelement 15 und/oder das elektronische Bauelement 22 können beispielsweise mittels der Leiterbahnen, Anschlussstellen der Leiterplatte 12, Kontaktstellen des Trägerelements 11 und/oder nicht dargestellten Kabelverbindungen elektrisch miteinander gekoppelt sein. Beispielsweise können der optoelektronischen Baugruppe 10 über das Steckerelement 16 von außen Steuerbefehle und/oder elektrische Energie zugeführt werden.

Die optoelektronische Baugruppe 10 gemäß dem Stand der Technik kann ferner ein nicht dargestelltes Dichtelement aufweisen, das beispielsweise die Leiterbahnen der Leiterplatte 12 und/oder das elektronische Bauelement 22 vor Feuchtigkeit schützt. Das Dichtelement kann im Querschnitt beispielsweise kappenförmig ausgebildet sein und sich der Leiterplatte 12 entsprechend, beispielsweise kreisförmig, über die gesamte Leiterplatte 12 erstrecken.

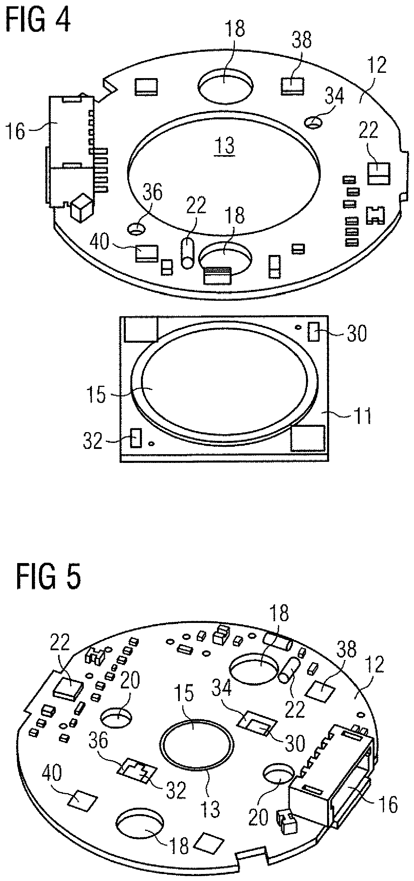

**Fig. 4** zeigt eine Explosionsdarstellung eines Ausführungsbeispiels einer Leiterplatte 12 und eines Trägerelements 11 mit einem optoelektronischen Bauelement 15. Die Leiterplatte 12, das Trägerelement 11 und das optoelektronische Bauelement 15 können beispielsweise weitgehend der im Vorhergehenden erläuterten Leiterplatte 12, dem Trägerelement 11 bzw. dem optoelektronischen Bauelement 15 entsprechen. Im Unterschied dazu weist die Leiterplatte 12 jedoch Kontaktausnehmungen auf, insbesondere eine erste Kontaktausnehmung 34 und eine zweite Kontaktausnehmung 36. Die erste Kontaktausnehmung 34 ist benachbart zu einer ersten Anschlussstelle 38 der Leiterplatte 12 ausgebildet. Die zweite Kontaktausnehmung 36 ist benachbart zu einer zweiten Anschlussstelle 40 der Leiterplatte 12 ausgebildet. Die Anschlussstellen 38, 40 der Leiterplatte 12 sind elektrisch mit den Leiterbahnen der Leiterplatte 12 verbunden.

Das Trägerelement 11 weist Kontaktstellen auf, insbesondere eine erste Kontaktstelle 30 und eine zweite Kontaktstelle 32. Die Kontaktstellen 30, 32 des Trägerelements 11 sind beispielsweise mittels nicht dargestellter Leiterbahnen des Trägerelements 11 mit dem optoelektronischen Bauelement 15 elektrisch verbunden. Bei bestimmungsgemäßen Anordnen der Leiterplatte 12 auf dem Trägerelement 11 ist das optoelektronische Bauelement 15 in der zentralen Ausnehmung 13 der Leiterplatte 12 freigelegt, die erste Kontaktstelle 30 ist in der ersten Kontaktausnehmung 34 freigelegt und die zweite Kontaktstelle 32 ist in der zweiten Kontaktausnehmung 36 freigelegt. Ansonsten ist die der Leiterplatte 12 zugewandte erste Seite des Trägerelements 11 von der Leiterplatte 12 bedeckt und kann beispielsweise mittels einer Klebeverbindung an dieser befestig werden. Das optoelektronische Bauelement 15 kann dann mit den Leiterbahnen der Leiterplatte 12, dem elektronischen Bauelement 22 und/oder dem Steckerelement 16 über die Anschlussstellen 38, 40, die Kontaktausnehmungen 34, 36 und die Kontaktstellen 30, 32 elektrisch gekoppelt werden.

**Fig. 5** zeigt eine perspektivische Ansicht eines Ausführungsbeispiels einer Leiterplatte 12 und eines optoelektronischen Bauelements 15. Die Leiterplatte 12 und das optoelektronische Bauelement 15 können beispielsweise weitgehend einer der im Vorhergehenden erläuterten Leiterplatte 12 bzw. einem im Vorhergehenden erläuterten optoelektronischen Bauelement 15 entsprechen. Beispielsweise können die Leiterplatte 12 und das optoelektronische Bauelement 15 weitgehend der in Figur 4 gezeigten Leiterplatte 12 bzw. dem in Figur 4 gezeigten optoelektronische Bauelement 15 entsprechen, wobei in Figur 5 das Trägerelement 11 weitgehend von der Leiterplatte 12 bedeckt ist.

Bei dem in Figur 5 gezeigten Ausführungsbeispiel sind die zentrale Ausnehmung 13 der Leiterplatte und das optoelektronische Bauelement 15 zueinander korrespondierend mit einem relativ zu der gesamten Leiterplatte 12 kleineren Durchmesser als bei dem in Figur 4 gezeigten Ausführungsbeispiel ausgebildet. Ferner sind die Kontaktausnehmungen 34, 36 beispielsweise rechteckförmig ausgebildet. Aus Figur 5 geht ferner hervor, dass bei an der Leiterplatte 12 befestigtem Trägerelement 11 die Kontaktstellen 30, 32 in den entsprechenden Kontaktausnehmungen 34, 36 freigelegt sind.

Ferner weist die Leiterplatte 12 zum Befestigen des Gehäusekörpers 14 an der Leiterplatte 12 optionale Befestigungsausnehmungen 20 der Leiterplatte 12 auf, in die in Figur 5 nicht gezeigte Befestigungsstifte des Gehäusekörpers 14 einführbar sind.

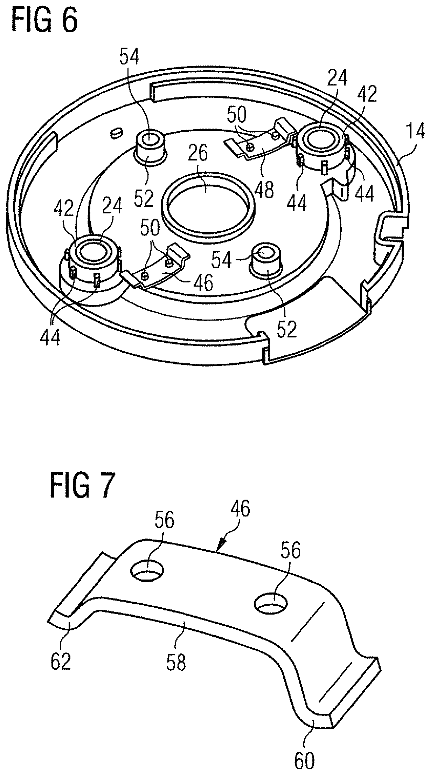

**Fig. 6** zeigt eine Innenseite eines Ausführungsbeispiels eines Gehäusekörpers 14, der beispielsweise in Verbindung mit der in Figur 5 gezeigten Leiterplatte 12 verwendet werden kann und/oder der einem der im Vorhergehenden erläuterten Gehäusekörper 14 entsprechen kann.

Der Gehäusekörper 14 weist die Montageausnehmungen 24 auf, wobei die Montageausnehmungen 24 von Wandungen 42 der Montageausnehmungen 24 begrenzt sind. Die Wandungen 42 können beispielsweise einstückig mit dem Gehäusekörper 14 ausgebildet sein oder an diesem befestigt werden.

Die Wandungen weisen optional an ihrem Außenumfang Montagerippen 44 auf, durch die in den entsprechenden einzelnen Sektionen der Wandungen 42 der Außenumfang der Wandungen 42 vergrößert wird. Beispielsweise können die Wandungen 42 und die Montagerippen 44 so ausgebildet sein, dass Außenumfänge der Wandungen 42 zwischen den Montagerippen 44 mit einer Spielpassung zu den Montageausnehmungen 18 der Leiterplatte 12 ausgebildet sind, so dass die Wandungen 42 einfach in die Montageausnehmungen 18 einführbar sind. Im Bereich der Montagerippen 44 kann der Außenumfang der Wandungen 42 derart vergrößert sein, dass im Bereich der Montagerippen 44 Übermaßpassungen zu den Montageausnehmungen 18 der Leiterplatte 12 gebildet sind. Dies bewirkt, dass beim Einführen der Wandungen 42 in die Montageausnehmungen 18 der Leiterplatte 12 eine kraftschlüssige Verbindung mittels einer Presspassung zwischen den Wandungen 42 und der Leiterplatte 12 und damit zwischen der Leiterplatte 12 und dem Gehäusekörper 14 entsteht.

Optional kann die Verbindung zwischen dem Gehäusekörper 14 und der Leiterplatte 12 weiter verstärkt werden, beispielsweise mittels einer zusätzlichen kraftschlüssigen Verbindung. Dazu sind beispielsweise Befestigungsstifte 52 an der Innenseite des Gehäusekörpers 14 angeordnet. Die Befestigungsstifte 52 sind so ausgebildet und angeordnet, dass sie bei bestimmungsgemäßen Anordnen des Gehäusekörpers 14 auf der Leiterplatte 12 zumindest teilweise in den Befestigungsausnehmungen 20 der Leiterplatte 12 angeordnet sind. Die Befestigungsstifte 52 können beispielsweise eine leichte Übermaßpassung zu den Befestigungsausnehmungen 20 aufweisen, so dass schon beim Einstecken der Befestigungsstifte 52 in die Befestigungsausnehmungen 20 die kraftschlüssige Verbindung entsteht. Alternativ dazu können die Befestigungsstifte 52 beispielsweise mittels einer Spielpassung zu den Befestigungsausnehmungen 20 und so lang ausgebildet sein, dass sie bei bestimmungsgemäßen Anordnen des Gehäusekörpers 14 einfach durch die Befestigungsausnehmungen 20 führbar sind und aus den Befestigungsausnehmungen 20 an der zweiten Seite der Leiterplatte 12 hervorragen. Der dann durch die Leiterplatte 12 hindurch ragende Teil der Befestigungsstifte 52 kann verformt werden, so dass eine formschlüssige Verbindung zwischen dem Gehäusekörper 14 und der Leiterplatte 12 entsteht und die Befestigungsstifte 52 nicht mehr ohne Zerstörung zurück durch die Befestigungsausnehmungen 20 gezogen werden können. Diese Verformung kann beispielsweise mittels Heißprägens (Hotstamp) erfolgen.

An der Innenseite des Gehäusekörpers 14 sind Kontaktelemente, insbesondere ein erstes Kontaktelement 46 und ein zweites Kontaktelement 46, angeordnet. Die Kontaktelemente 46, 48 können beispielsweise jeweils mittels Haltestifte 50 an der Innenseite des Gehäusekörpers 14 befestigt sein. Optional können die Kontaktelemente 46, 48 an dem Gehäusekörper 14 festgeklebt sein. Die Kontaktelemente 46, 48 sind so ausgebildet und angeordnet, dass sie bei bestimmungsgemäßen Anordnen des Gehäusekörpers 14 auf der Leiterplatte 12 je eine Kontaktstelle 30, 32 des Trägerelements 11 mit je einer Anschlussstelle 38, 40 der Leiterplatte 12 elektrisch koppeln. In anderen Worten dienen die Kontaktelemente 46, 48 zum elektrischen Verbinden der Kontaktstellen 30, 32 mit den Anschlussstellen 38, 40. Beispielsweise kann das erste Kontaktelement 46 die erste Kontaktstelle 30 mit der ersten Anschlussstelle 38 elektrisch koppeln und/oder das zweite Kontaktelement 48 kann die zweite Kontaktstelle 32 mit der zweiten Anschlussstelle 40 elektrisch koppeln. Das elektrische Koppeln der Kontaktstellen 30, 32 mit den Anschlussstellen 38, 40 erfolgt dabei automatisch beim Anordnen des Gehäusekörpers 14 auf der Leiterplatte 12 und benötigt keine weiteren Arbeitsschritte oder Verbindungsmittel, wie beispielsweise Kabel, Drähte und/oder Lötverbindungen.

**Fig. 7** zeigt eine perspektivische Ansicht eines Ausführungsbeispiels eines der Kontaktelemente, beispielsweise des ersten Kontaktelements 46. Das zweite Kontaktelement 48 kann beispielsweise dem ersten Kontaktelement 46 entsprechend ausgebildet sein. Das erste Kontaktelement 46 weist mindestens eine Halteausnehmung, beispielsweise zwei Halteausnehmungen 56 auf. Die Halteausnehmungen 56 sind so ausgebildet und angeordnet, dass die Haltestifte 50 in sie einführbar sind. Beispielsweise können die Haltestifte 50 mit einer Übermaßpassung zu den Halteausnehmungen 56 des ersten Kontaktelements 46 ausgebildet sein, so dass schon beim Einstecken der Haltestifte 50 in die Halteausnehmungen 56 des ersten Kontaktelements 46 eine kraftschlüssige Verbindung, insbesondere mittels einer Presspassung, zwischen dem ersten Kontaktelement 46 und dem Gehäusekörper 14 erfolgt. Alternativ dazu können die Haltestifte 50 mit einer Spielpassung zu den Halteausnehmungen 56 des ersten Kontaktelements 46 ausgebildet sein und so lang ausgebildet sein, dass sie bei bestimmungsgemäßen Anordnen des ersten Kontaktelements 46 an dem Gehäusekörpers 14 durch die entsprechende Halteausnehmung 56 des ersten Kontaktelements 46 hindurch ragen. Der hindurchragende Teil des entsprechenden Haltestifts 50 kann dann derart verformt werden, dass er nicht mehr durch die entsprechende Halteausnehmung 56 des ersten Kontaktelements 46 zurückziehbar ist. Beispielsweise kann nach dem Verformen der verformte Teil des Haltestifts 50 eine deutliche Übermaßpassung zu der entsprechenden Halteausnehmung 56 des ersten Kontaktelements 46 aufweisen.

Das erste Kontaktelement 46 kann beispielsweise einen mittleren Abschnitt 58, einen ersten Endabschnitt 60 und einen zweiten Endabschnitt 62 aufweisen. Das erste Kontaktelement 46 kann in an dem Gehäusekörper 14 angeordnetem Zustand beispielsweise an dem mittleren Abschnitt 58 in Kontakt mit der Innenseite des Gehäusekörpers 14 sein. Die Endabschnitte 60, 62 stehen dann jeweils von der Innenseite des Gehäusekörpers 14 ab. Die Endabschnitte 60, 62 können von dem mittleren Abschnitt 58 weg gebogen sein, beispielsweise derart, dass beim Pressen der Endabschnitte 60, 62 in Richtung hin zu dem Gehäusekörper 14 das erste Kontaktelement 46 elastisch verformt wird, wodurch eine Federwirkung entsteht und das erste Kontaktelement 46 als Federelement ausgebildet ist. Insbesondere können die Endabschnitte 60, 62 derart ausgebildet sein, dass bei bestimmungsgemäßem Anordnen des Gehäusekörpers 14 auf der Leiterplatte 12 die erste Kontaktstelle 30 auf den ersten Endabschnitt 60 einen Druck ausübt und die erste Anschlussstelle 38 auf den zweiten Endabschnitt 62 einen Druck ausübt und die beiden Endabschnitte 60, 62 elastisch verformt werden, wobei von den Endabschnitten 60, 62 einen Gegendruck auf die entsprechende Kontaktstelle 30 bzw. Anschlussstelle 38 ausgeübt wird. Dies kann dazu beitragen, eine besonders zuverlässige elektrische Kopplung zwischen der entsprechenden Kontaktstelle 30 und Anschlussstelle 38 zu realisieren.

Das erste Kontaktelement 46 kann beispielsweise Metall aufweisen oder daraus gebildet sein. Beispielsweise kann das erste Kontaktelement 46 eine Legierung aufweisen. Beispielsweise kann die Legierung korrosionsbeständig sein. Beispielsweise kann das erste Kontaktelement 46 einen Metallkern aufweisen, der mit einer Legierung beschichtet ist. Die Kontaktelemente 46, 48 können beispielsweise jeweils als Stanzbiegeteil ausgebildet sein.

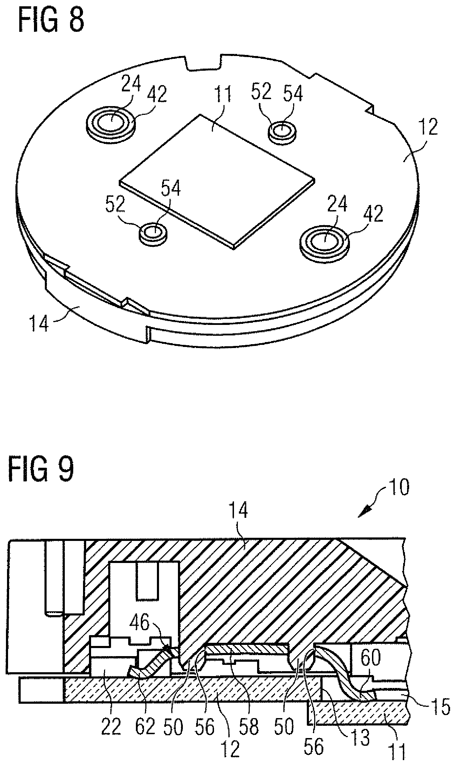

**Fig. 8** zeigt eine Unterseite eines Ausführungsbeispiels einer optoelektronischen Baugruppe 10. Die optoelektronische Baugruppe 10 kann beispielsweise durch die in Figur 5 gezeigte Leiterplatte 12 und das entsprechende optoelektronische Bauelement 15 und den in Figur 6 gezeigten Gehäusekörper 14 gebildet sein.

Aus Figur 8 geht hervor, dass die Befestigungsstifte 52 und die Wandungen 42 der Montageausnehmungen 24 an der zweiten Seite der Leiterplatte 12 aus der Leiterplatte 12 hervorragen. Beispielsweise können die Befestigungsstifte 52 und die Wandungen 42 derart durch die Leiterplatte 12 hindurch ragen, dass deren Endabschnitte bündig mit der zweiten Seite des Trägerelements 11 ausgebildet sind.

Optional können die Befestigungsstifte 52 Ausnehmungen 54 der Befestigungsstifte 52 aufweisen. Die Ausnehmungen 54 der Befestigungsstifte 52 können beispielsweise zum Aufnehmen von Schrauben dienen. Die Schrauben können dazu beitragen, die Leiterplatte 12 lösbar an dem Gehäusekörper 14 festzulegen. Beim Verwenden der Schrauben können die Befestigungsstifte 52 derart ausgebildet sein, dass nicht die Befestigungsstifte 52 selbst sondern die oberen Enden der Köpfe der verwendeten Schrauben bündig mit der zweiten Seite des Trägerelements 11 sind.

**Fig. 9** zeigt eine Schnittdarstellung durch einen Teil eines Ausführungsbeispiels einer optoelektronischen Baugruppe, beispielsweise der optoelektronischen Baugruppe 10, die mittels der in Figur 5 gezeigten Leiterplatte 12 und dem entsprechenden optoelektronischen Bauelement 15 und dem in Figur 6 gezeigten Gehäusekörper 14 gebildet ist.

Insbesondere zeigt Figur 9, wie bei bestimmungsgemäß an der Leiterplatte 12 angeordnetem Gehäusekörper 14 das erste Kontaktelement 46 die erste Kontaktstelle 30 mit der ersten Anschlussstelle 38 elektrisch koppelt, wobei der erste Endabschnitt 60 in körperlichem Kontakt mit der ersten Kontaktstelle 30 des Trägerelements 11 ist und der zweite Endabschnitt 62 in körperlichem Kontakt mit der ersten Anschlussstelle 38 der Leiterplatte 12 ist.

Ferner zeigt Figur 9, wie bei bestimmungsgemäß an dem Gehäusekörper 14 angeordnetem ersten Kontaktelement 46 die Haltestifte 50 durch die Halteausnehmungen 56 des ersten Kontaktelements 46 hindurch ragen und wie bei bestimmungsgemäß an der Leiterplatte 12 angeordnetem Gehäusekörper 14 das erste Kontaktelement 46 aufgrund des Drucks der Leiterplatte 12 und des Trägerelements 11 in Richtung hin zu dem Gehäusekörper 14 elastisch verformt ist.

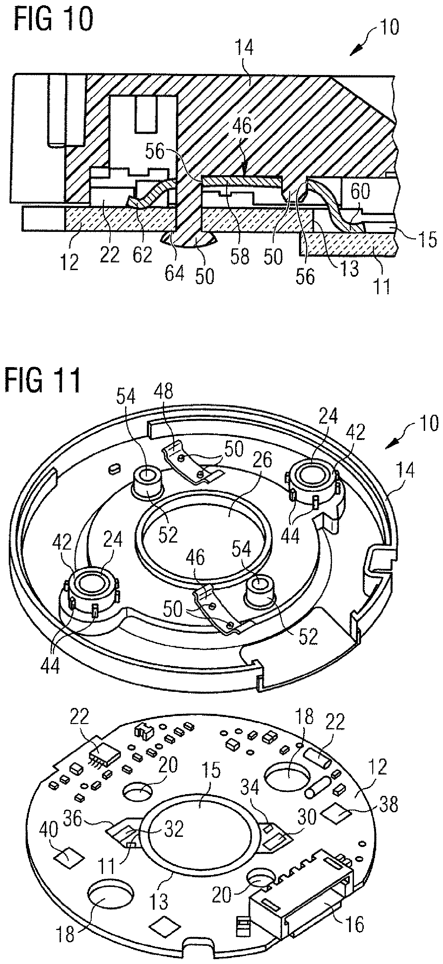

**Fig. 10** zeigt eine Schnittdarstellung durch ein Ausführungsbeispiel einer optoelektronischen Baugruppe 10, die beispielsweise weitgehend der in Figur 9 dargestellten optoelektronischen Baugruppe 10 entsprechen kann, wobei im Unterschied dazu die Leiterplatte 12 eine Halteausnehmung 64 der Leiterplatte 12 aufweist und einer der Haltestifte 50 so ausgebildet und angeordnet ist, dass er nicht nur durch die Halteausnehmung 56 des ersten Kontaktelements 46, sondern auch durch die Halteausnehmung 64 der Leiterplatte 12 hindurch ragt. Der entsprechende Haltestift 50 kann an seinem durch die Leiterplatte 12 hindurch ragendem Endabschnitt derart verformt sein, dass er nicht mehr ohne Zerstörung durch die Halteausnehmung 64 der Leiterplatte 12 zurückziehbar ist. Dadurch kann eine formschlüssige und/oder nicht lösbare Verbindung zwischen dem Gehäusekörper 14 und der Leiterplatte 12 erzeugt werden. Das Verformen des Haltestifts 50 kann beispielsweise mittels Heißprägens erfolgen.

**Fig. 11** zeigt eine perspektivische Ansicht einer Innenseite eines Gehäusekörpers 14 und einer ersten Seite einer Leiterplatte 12, die beispielsweise weitgehend dem in Figur 6 gezeigten Gehäusekörper 14 bzw. der in Figur 5 gezeigten Leiterplatte 12 entsprechen können. Im Unterschied dazu sind jedoch die Kontaktstellen 30, 32, die entsprechenden Kontaktausnehmungen 34, 36, die entsprechenden Anschlussstellen 38, 40 und die entsprechenden Kontaktelemente 46, 48 relativ zu den Montageausnehmungen 24 und Befestigungsstiften 52 anders angeordnet. Darüber hinaus ist das optoelektronische Bauelement 15 relativ zu der Leiterplatte 12 etwas größer ausgebildet und die zentrale Ausnehmung 13 der Leiterplatte 12 ist dementsprechend größer ausgebildet.

Ferner münden optional die Kontaktausnehmungen 34, 36 in die zentrale Ausnehmung 13 der Leiterplatte 12. In anderen Worten sind die zentrale Ausnehmung 13 und die Kontaktausnehmungen 34, 36 einstückig ausgebildet. In wieder anderen Worten bilden die Kontaktausnehmungen 34, 36 und die zentrale Ausnehmung 13 eine gemeinsame große Ausnehmung.

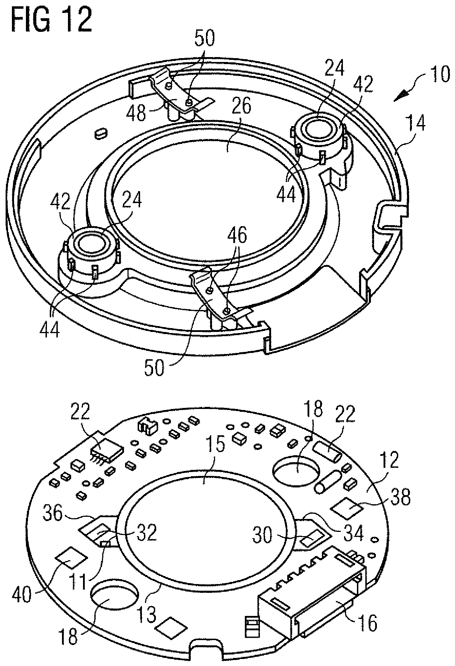

**Fig. 12** zeigt eine Innenseite eines Ausführungsbeispiels eines Gehäusekörpers 14 und eine erste Seite eines Ausführungsbeispiels einer Leiterplatte 12, die beispielsweise weitgehend dem in Figur 11 gezeigten Gehäusekörper 14 bzw. der in Figur 11 gezeigten Leiterplatte 12 entsprechen können. Im Unterschied dazu ist jedoch das optoelektronische Bauelement 15 größer ausgebildet und die zentrale Ausnehmung 13 der Leiterplatte 12 ist dementsprechend größer ausgebildet. Darüber hinaus ist bei dem in Figur 12 gezeigten Ausführungsbeispiel auf die Befestigungsstifte 52 verzichtet worden.

Mittels der optoelektronischen Baugruppen 10 kann Licht unterschiedlicher Lumenwerte erzeugt werden. Beispielsweise können mittels des in Figur 5 gezeigten optoelektronischen Bauelements 15 und der entsprechenden Leiterplatte 12 Lumenwerte im Bereich von beispielsweise 500 Lumen bis 1500 Lumen, beispielsweise 600 Lumen bis 1000 Lumen, beispielsweise ungefähr 800 Lumen erreicht werden. Mit dem in Figur 11 gezeigten optoelektronischen Bauelement 15 und der entsprechenden Leiterplatte 12 kann beispielsweise Licht mit Lumenwerten im Bereich von 1500 Lumen bis 2500 Lumen, beispielsweise im Bereich von 1900 bis 2100 Lumen, beispielsweise ungefähr 2000 Lumen erreicht werden. Mit dem in Figur 12 gezeigten optoelektronischen Bauelement 15 und der entsprechenden Leiterplatte 12 kann beispielsweise Licht mit Lumenwerten im Bereich von 4000 bis 6000, beispielsweise im Bereich von 4500 bis 5500 Lumen, beispielsweise ungefähr 5000 Lumen erreicht werden.

Die Erfindung ist nicht auf die angegebenen Ausführungsbeispiele beschränkt. Beispielsweise können mehr oder weniger optoelektronische Bauelemente 15 in einer optoelektronischen Baugruppe 10 angeordnet sein. Ferner können die optoelektronischen Baugruppen 10 mehr oder weniger Montageausnehmungen 24 aufweisen. Ferner können die optoelektronischen Baugruppen 10 und insbesondere die Gehäusekörper 14 andere äußere Formen aufweisen. Beispielsweise können die optoelektronischen Baugruppen 10 eckig, beispielsweise rechteckig oder quadratisch ausgebildet sein.

## Patentansprüche

1. Optoelektronische Baugruppe (10) mit
- einer Leiterplatte (12), die eine erste Seite der Leiterplatte (12), eine von der ersten Seite abgewandte zweite Seite der Leiterplatte (12), eine zentrale Ausnehmung (13) der Leiterplatte (12), mindestens eine Kontaktausnehmung (34, 36) und auf der ersten Seite der Leiterplatte (12) mindestens eine Anschlussstelle (38, 40) aufweist,
- einem Trägerelement (11), das mit der Leiterplatte (12) körperlich gekoppelt ist, das eine erste Seite des Trägerelements (11) aufweist, die der zweiten Seite der Leiterplatte (12) zugewandt ist, und das auf der ersten Seite des Trägerelements (11) mindestens eine Kontaktstelle (30, 32) aufweist, wobei die Kontaktstelle (30, 32) in der Kontaktausnehmung (34, 36) der Leiterplatte (12) freigelegt ist,
- mindestens einem optoelektronischen Bauelement (15), das über das Trägerelement (11) mit der Kontaktstelle (30, 32) des Trägerelements (11) elektrisch gekoppelt ist und das so auf der ersten Seite des Trägerelements (11) angeordnet ist, dass es in der zentralen Ausnehmung (13) der Leiterplatte (12) freigelegt ist,
- einem Gehäusekörper (14), der eine zentrale Ausnehmung (26) aufweist und der so ausgebildet und so mit der Leiterplatte (12) körperlich gekoppelt ist, dass das optoelektronische Bauelement (15) in der zentralen Ausnehmung (26) des Gehäusekörpers (14) freigelegt ist,
- mindestens einem Kontaktelement (46, 48), das so ausgebildet ist, dass das Kontaktelement (46, 48) die Kontaktstelle (30, 32) des Trägerelements (11) mit der Anschlussstelle (38, 40) der Leiterplatte (12) elektrisch koppelt,
**dadurch gekennzeichnet, dass** das Kontaktelement (46, 48) an einer Innenseite des Gehäusekörpers (14) angeordnet ist.

2. Optoelektronische Baugruppe (10) nach Anspruch 1, bei der das Kontaktelement (46, 48) einen mittleren Abschnitt (58), über den das Kontaktelement (46, 48) an dem Gehäusekörper (14) befestigt ist, einen ersten Endabschnitt (60), der von dem Gehäusekörper (14) absteht und der mit der Kontaktstelle (30, 32) des Trägerelements (11) gekoppelt ist, und einen zweiten Endabschnitt (62) aufweist, der von dem Gehäusekörper (14) absteht und der mit der Anschlussstelle (38, 40) der Leiterplatte (12) gekoppelt ist.

3. Optoelektronische Baugruppe (10) nach einem der vorstehenden Ansprüche, bei der das Kontaktelement (46, 48) als Federelement ausgebildet ist.

4. Optoelektronische Baugruppe (10) nach einem der vorstehenden Ansprüche, bei der der Gehäusekörper (14) an seiner Innenseite mindestens einen Haltestift (50) aufweist und bei der das Kontaktelement (46, 48) mindestens eine Halteausnehmung (56) des Kontaktelements (46, 48) aufweist und bei der der Haltestift (50) durch die Halteausnehmung (56) des Kontaktelements (46, 48) ragt.

5. Optoelektronische Baugruppe (10) nach Anspruch 4, bei der der Teil des Haltestifts (50), der durch die Halteausnehmung (56) des Kontaktelements (46, 48) ragt, mit einer Übermaßpassung zu der Halteausnehmung (56) des Kontaktelements (46, 48) ausgebildet ist.

6. Optoelektronische Baugruppe (10) nach Anspruch 4 oder 5, bei der die Leiterplatte (12) eine Halteausnehmung (64) der Leiterplatte (12) aufweist und bei der der Haltestift (50) durch die Halteausnehmung (64) der Leiterplatte (12) ragt.

7. Optoelektronische Baugruppe (10) nach Anspruch 6, bei der der Teil des Haltestifts (50), der durch die Halteausnehmung (64) der Leiterplatte (12) ragt, mit einer Übermaßpassung zu der Halteausnehmung (64) der Leiterplatte (12) ausgebildet ist.

8. Optoelektronische Baugruppe (10) nach einem der Ansprüche 6 oder 7, bei der der Haltestift (50) so weit durch die Halteausnehmung (64) der Leiterplatte (12) ragt, dass ein Endabschnitt des Haltestifts (50) mit einer zweiten Seite des Trägerelements (11), die von der ersten Seite des Trägerelements (11) abgewandt ist, bündig ist.

9. Optoelektronische Baugruppe (10) nach einem der vorstehenden Ansprüche, bei der der Gehäusekörper (14) mindestens eine Montageausnehmung (24) des Gehäusekörpers (14) aufweist, die so ausgebildet ist, dass eine Wandung (42) der Montageausnehmung (24) des Gehäusekörpers (14) durch eine Montageausnehmung (18) der Leiterplatte (12) ragt.

10. Optoelektronische Baugruppe (10) nach Anspruch 9, bei der die Wandung (42) so weit durch die Montageausnehmung (18) der Leiterplatte (12) ragt, dass ein Endabschnitt der Wandung (42) mit einer zweiten Seite des Trägerelements (11), die von der ersten Seite des Trägerelements (11) abgewandt ist, bündig ist.

11. Optoelektronische Baugruppe (10) nach einem der Ansprüche 9 oder 10, bei der an einer Außenseite der Wandung (42) Montagerippen (44) ausgebildet sind, wobei die Außenseite der Wandung (42) zwischen den Montagerippen (44) mit einer Spielpassung zu der Montageausnehmung (18) der Leiterplatte (12) ausgebildet ist und die Montagerippen (44) gemäß einer Übermaßpassung zu der Montageausnehmung (18) der Leiterplatte (12) ausgebildet sind.

12. Optoelektronische Baugruppe (10) nach einem der vorstehenden Ansprüche, bei der der Gehäusekörper (14) an seiner Innenseite mindestens einen Befestigungsstift (52) aufweist, der so ausgebildet ist, dass er durch eine Befestigungsausnehmung (20) der Leiterplatte (12) ragt.

13. Optoelektronische Baugruppe (10) nach Anspruch 12, bei der der Befestigungsstift (52) so weit durch die Befestigungsausnehmung (20) der Leiterplatte (12) ragt, dass ein Endabschnitt des Befestigungsstifts (52) mit einer zweiten Seite des Trägerelements (11), die von der ersten Seite des Trägerelements (11) abgewandt ist, bündig ist.

14. Optoelektronische Baugruppe (10) nach einem der vorstehenden Ansprüche, bei der die Kontaktausnehmung (34, 36) in die zentrale Ausnehmung (13) der Leiterplatte (12) mündet.

15. Verfahren zum Herstellen einer optoelektronischen Baugruppe (10), bei dem
- ein Trägerelement (11) bereitgestellt wird, das eine erste Seite des Trägerelements (11) und auf der ersten Seite des Trägerelements (11) mindestens eine Kontaktstelle (30, 32) aufweist,
- mindestens ein optoelektronisches Bauelement (15) auf der ersten Seite des Trägerelements (11) angeordnet wird und über das Trägerelement (11) mit den beiden Kontaktstellen (30, 32) elektrisch gekoppelt wird,
- eine Leiterplatte (12) bereitgestellt wird, die eine erste Seite der Leiterplatte (12), eine von der ersten Seite der Leiterplatte (12) abgewandte zweite Seite der Leiterplatte (12), eine zentrale Ausnehmung (13), mindestens eine Kontaktausnehmung (30, 32) und auf der ersten Seite der Leiterplatte (12) mindestens eine Anschlussstelle (38, 40) aufweist,
- das Trägerelement (11) so mit der Leiterplatte (12) körperlich gekoppelt wird, dass die erste Seite des Trägerelements (11) der zweiten Seite der Leiterplatte (12) zugewandt ist, dass das optoelektronische Bauelement (15) in der zentralen Ausnehmung (13) der Leiterplatte (12) freigelegt ist und dass die Kontaktstelle (30, 32) des Trägerelements (11) in der Kontaktausnehmung (34, 36) der Leiterplatte (12) freigelegt ist,
- ein Gehäusekörper (14) bereitgestellt wird, der eine zentrale Ausnehmung (26) aufweist und an dessen Innenseite mindestens ein elektrisch leitfähiges Kontaktelement (46, 48) angeordnet ist,
- der Gehäusekörper (14) so mit der Leiterplatte (12) körperlich gekoppelt wird, dass das optoelektronische Bauelement (15) in der zentralen Ausnehmung (26) des Gehäusekörpers (14) freigelegt ist und das Kontaktelement (46, 48) die Kontaktstelle (30, 32) des Trägerelements (11) mit der Anschlussstelle (38, 40) der Leiterplatte (12) elektrisch koppelt.

16. Verfahren nach Anspruch 15, bei dem das Kontaktelement (46, 48) mittels eines Haltestifts (50) des Gehäusekörpers (14) und einer dazu korrespondieren Halteausnehmung (50) des Kontaktelements (46, 48) an dem Gehäusekörper (14) befestigt wird.

## Claims

1. Optoelectronic assembly (10) comprising
- a printed circuit board (12), which has a first side of the printed circuit board (12), a second side of the printed circuit board (12) facing away from the first side, a central cutout (13) of the printed circuit board (12), at least one contact cutout (34, 36) and, on the first side of the printed circuit board (12), at least one connection location (38, 40),
- a carrier element (11), which is physically coupled to the printed circuit board (12), has a first side of the carrier element (11), said first side facing the second side of the printed circuit board (12), and has at least one contact location (30, 32) on the first side of the carrier element (11), wherein the contact location (30, 32) is exposed in the contact cutout (34, 36) of the printed circuit board (12),
- at least one optoelectronic component (15) which is electrically coupled to the contact location (30, 32) of the carrier element (11) via the carrier element (11) and which is arranged on the first side of the carrier element (11) in such a way that it is exposed in the central cutout (13) of the printed circuit board (12),
- a housing body (14), which has a central cutout (26) and which is formed and physically coupled to the printed circuit board (12) in such a way that the optoelectronic component (15) is exposed in the central cutout (26) of the housing body (14),
- at least one contact element (46, 48) which is formed in such a way that the contact element (46, 48) electrically couples the contact location (30, 32) of the carrier element (11) to the connection location (38, 40) of the printed circuit board (12),
**characterized in that** the contact element (46, 48) is arranged on an inner side of the housing body (14).

2. Optoelectronic assembly (10) according to Claim 1, wherein the contact element (46, 48) has a middle section (58), via which the contact element (46, 48) is fixed to the housing body (14), a first end section (60), which projects from the housing body (14) and which is coupled to the contact location (30, 32) of the carrier element (11), and a second end section (62), which projects from the housing body (14) and which is coupled to the connection location (38, 40) of the printed circuit board (12).

3. Optoelectronic assembly (10) according to either of the preceding claims, wherein the contact element (46, 48) is formed as a spring element.

4. Optoelectronic assembly (10) according to any of the preceding claims, wherein the housing body (14) has at least one holding pin (50) on its inner side, and wherein the contact element (46, 48) has at least one holding cutout (56) of the contact element (46, 48), and wherein the holding pin (50) projects through the holding cutout (56) of the contact element (46, 48).

5. Optoelectronic assembly (10) according to Claim 4, wherein the part of the holding pin (50) which projects through the holding cutout (56) of the contact element (46, 48) is formed with an interference fit with respect to the holding cutout (56) of the contact element (46, 48).

6. Optoelectronic assembly (10) according to Claim 4 or 5, wherein the printed circuit board (12) has a holding cutout (64) of the printed circuit board (12), and wherein the holding pin (50) projects through the holding cutout (64) of the printed circuit board (12).

7. Optoelectronic assembly (10) according to Claim 6, wherein the part of the holding pin (50) which projects through the holding cutout (64) of the printed circuit board (12) is formed with an interference fit with respect to the holding cutout (64) of the printed circuit board (12).

8. Optoelectronic assembly (10) according to either of Claims 6 and 7, wherein the holding pin (50) projects through the holding cutout (64) of the printed circuit board (12) to an extent such that an end section of the holding pin (50) is flush with a second side of the carrier element (11) facing away from the first side of the carrier element (11).

9. Optoelectronic assembly (10) according to any of the preceding claims, wherein the housing body (14) has at least one mounting cutout (24) of the housing body (14) which is formed in such a way that a wall (42) of the mounting cutout (24) of the housing body (14) projects through a mounting cutout (18) of the printed circuit board (12).

10. Optoelectronic assembly (10) according to Claim 9, wherein the wall (42) projects through the mounting cutout (18) of the printed circuit board (12) to an extent such that an end section of the wall (42) is flush with a second side of the carrier element (11) facing away from the first side of the carrier element (11).

11. Optoelectronic assembly (10) according to either of Claims 9 and 10, wherein mounting ribs (44) are formed on an outer side of the wall (42), wherein the outer side of the wall (42) between the mounting ribs (44) is formed with a clearance fit with respect to the mounting cutout (18) of the printed circuit board (12), and the mounting ribs (44) are formed in accordance with an interference fit with respect to the mounting cutout (18) of the printed circuit board (12).

12. Optoelectronic assembly (10) according to any of the preceding claims, wherein the housing body (14) has on its inner side at least one fixing pin (52) which is formed in such a way that it projects through a fixing cutout (20) of the printed circuit board (12).

13. Optoelectronic assembly (10) according to Claim 12, wherein the fixing pin (52) projects through the fixing cutout (20) of the printed circuit board (12) to an extent such that an end section of the fixing pin (52) is flush with a second side of the carrier element (11) facing away from the first side of the carrier element (11).

14. Optoelectronic assembly (10) according to any of the preceding claims, wherein the contact cutout (34, 36) opens into the central cutout (13) of the printed circuit board (12) .

15. Method for producing an optoelectronic assembly (10), wherein
- a carrier element (11) is provided, which has a first side of the carrier element (11) and at least one contact location (30, 32) on the first side of the carrier element (11),
- at least one optoelectronic component (15) is arranged on the first side of the carrier element (11) and is electrically coupled to the two contact locations (30, 32) via the carrier element (11),
- a printed circuit board (12) is provided, which has a first side of the printed circuit board (12), a second side of the printed circuit board (12) facing away from the first side of the printed circuit board (12), a central cutout (13), at least one contact cutout (30, 32) and, on the first side of the printed circuit board (12), at least one connection location (38, 40),
- the carrier element (11) is physically coupled to the printed circuit board (12) in such a way that the first side of the carrier element (11) faces the second side of the printed circuit board (12), that the optoelectronic component (15) is exposed in the central cutout (13) of the printed circuit board (12), and that the contact location (30, 32) of the carrier element (11) is exposed in the contact cutout (34, 36) of the printed circuit board (12),
- a housing body (14) is provided, which has a central cutout (26) and on the inner side of which at least one electrically conductive contact element (46, 48) is arranged,
- the housing body (14) is physically coupled to the printed circuit board (12) in such a way that the optoelectronic component (15) is exposed in the central cutout (26) of the housing body (14), and the contact element (46, 48) electrically couples the contact location (30, 32) of the carrier element (11) to the connection location (38, 40) of the printed circuit board (12).

16. Method according to Claim 15, wherein the contact element (46, 48) is fixed to the housing body (14) by means of a holding pin (50) of the housing body (14) and a holding cutout (50) of the contact element (46, 48) corresponding thereto.

## Revendications

1. Sous-ensemble optoélectronique (10) comprenant :
- une plaque conductrice (12) qui présente une première face de la plaque conductrice (12), une deuxième face de la plaque conductrice (12) détournée de la première face, un évidement central (13) de la plaque conductrice (12), au moins un évidement de contact (34, 36) et au moins un point de raccordement (38, 40) sur la première face de la plaque conductrice (12),
- un élément porteur (11) qui est couplé physiquement à la plaque conductrice (12), qui présente une première face de l'élément porteur (11) qui est tournée vers la deuxième face de la plaque conductrice (12), et qui présente au moins un point de contact (30, 32) sur la première face de l'élément porteur (11), dans lequel le point de contact (30, 32) est exposé dans l'évidement de contact (34, 36) de la plaque conductrice (12),
- au moins un sous-ensemble optoélectronique (15) qui est couplé électriquement au point de contact (30, 32) de l'élément porteur (11) par le biais de l'élément porteur (11) et qui est disposé sur la première face de l'élément porteur (11) de sorte à être exposé dans l'évidement central (13) de la plaque conductrice (12),
- un corps de logement (14) qui présente un évidement central (26) et qui est formé et couplé physiquement à la plaque conductrice (12) de sorte que le sous-ensemble optoélectronique (15) est exposé dans l'évidement central (26) du corps de logement (14),
- au moins un élément de contact (46, 48) qui est formé de sorte que l'élément de contact (46, 48) couple électriquement le point de contact (30, 32) de l'élément porteur (11) avec le point de raccordement (38, 40) de la plaque conductrice (12), **caractérisé en ce que** l'élément de contact (46, 48) est disposé sur une face intérieure du corps de logement (14).

2. Sous-ensemble optoélectronique (10) selon la revendication 1, dans lequel l'élément de contact (46, 48) présente un tronçon central (58) par lequel l'élément de contact (46, 48) est fixé sur le corps de logement (14), un premier tronçon d'extrémité (60) qui est éloigné du corps de logement (14) et qui est couplé au point de contact (30, 32) de l'élément porteur (11), et un deuxième tronçon d'extrémité (62) qui est éloigné du corps de logement (14) et qui est couplé au point de raccordement (38, 40) de la plaque conductrice (12).

3. Sous-ensemble optoélectronique (10) selon l'une des revendications précédentes, dans lequel l'élément de contact (46, 48) est formé en tant qu'élément ressort.

4. Sous-ensemble optoélectronique (10) selon l'une des revendications précédentes, dans lequel le corps de logement (14) présente sur sa face intérieure au moins une tige de retenue (50) et dans lequel l'élément de contact (46, 48) présente au moins un évidement de retenue (56) de l'élément de contact (46, 48) et dans lequel la tige de retenue (50) pénètre à travers l'évidement de retenue (56) de l'élément de contact (46, 48).

5. Sous-ensemble optoélectronique (10) selon la revendication 4, dans lequel la partie de la tige de retenue (50) qui pénètre à travers l'évidement de retenue (56) de l'élément de contact (46, 48) est formée avec un ajustage par sur-dimensionnement par rapport à l'évidement de retenue (56) de l'élément de contact (46, 48).

6. Sous-ensemble optoélectronique (10) selon la revendication 4 ou 5, dans lequel la plaque conductrice (12) présente un évidement de retenue (64) de la plaque conductrice (12) et dans lequel la tige de retenue (50) pénètre à travers l'évidement de retenue (64) de la plaque conductrice (12).

7. Sous-ensemble optoélectronique (10) selon la revendication 6, dans lequel la partie de la tige de retenue (50) qui pénètre à travers l'évidement de retenue (64) de la plaque conductrice (12) est formée avec un ajustage par sur-dimensionnement par rapport à l'évidement de retenue (64) de la plaque conductrice (12).

8. Sous-ensemble optoélectronique (10) selon l'une des revendications 6 ou 7, dans lequel la partie de la tige de retenue (50) pénètre si loin à travers l'évidement de retenue (64) de la plaque conductrice (12) qu'un tronçon d'extrémité de la tige de retenue (50) affleure avec une deuxième face de l'élément porteur (11) qui est détournée de la première face de l'élément porteur (11).

9. Sous-ensemble optoélectronique (10) selon l'une des revendications précédentes, dans lequel le corps de logement (14) présente au moins un évidement de montage (24) du corps de logement (14) qui est formé de sorte qu'une paroi (42) de l'évidement de montage (24) du corps de logement (14) pénètre à travers un évidement de montage (18) de la plaque conductrice (12).

10. Sous-ensemble optoélectronique (10) selon la revendication 9, dans lequel la paroi (42) pénètre si loin à travers l'évidement de montage (18) de la plaque conductrice (12) qu'un tronçon d'extrémité de la paroi (42) affleure avec une deuxième face de l'élément porteur (11) qui est détournée de la première face de l'élément porteur (11).

11. Sous-ensemble optoélectronique (10) selon l'une des revendications 9 ou 10, dans lequel des nervures de montage (44) sont formées sur une face extérieure de la paroi (42), dans lequel la face extérieure de la paroi (42) est formée entre les nervures de montage (44) avec un ajustage par jeu par rapport à l'évidement de montage (18) de la plaque conductrice (12) et les nervures de montage (44) sont formées selon un ajustage par sur-dimensionnement par rapport à l'évidement de montage (18) de la plaque conductrice (12).

12. Sous-ensemble optoélectronique (10) selon l'une des revendications précédentes, dans lequel le corps de logement (14) présente sur sa face intérieure au moins une tige de fixation (52) qui est formée de sorte qu'elle pénètre à travers un évidement de fixation (20) de la plaque conductrice (12).

13. Sous-ensemble optoélectronique (10) selon la revendication 12, dans lequel la tige de fixation (52) pénètre si loin à travers l'évidement de fixation (20) de la plaque conductrice (12) qu'un tronçon d'extrémité de la tige de fixation (52) affleure avec une deuxième face de l'élément porteur (11) qui est détournée de la première face de l'élément porteur (11).

14. Sous-ensemble optoélectronique (10) selon l'une des revendications précédentes, dans lequel l'évidement de contact (34, 36) débouche dans l'évidement central (13) de la plaque conductrice (12).

15. Procédé de fabrication d'un sous-ensemble optoélectronique (10), dans lequel
- un élément porteur (11) est fourni, qui présente une première face de l'élément porteur (11) et présente au moins un point de contact (30, 32) sur la première face de l'élément porteur (11),
- au moins un sous-ensemble optoélectronique (15) qui est disposé sur la première face de l'élément porteur (11) et est couplé électriquement aux deux points de contact (30, 32) par le biais de l'élément porteur (11),
- une plaque conductrice (12) est fournie, qui présente une première face de la plaque conductrice (12), une deuxième face de la plaque conductrice (12) détournée de la première face de la plaque conductrice (12), un évidement central (13), au moins un évidement de contact (34, 36) et au moins un point de raccordement (38, 40) sur la première face de la plaque conductrice (12),
- l'élément porteur (11) est couplé physiquement à la plaque conductrice (12) de sorte que la première face de l'élément porteur (11) est tournée vers la deuxième face de la plaque conductrice (12), que le sous-ensemble optoélectronique (15) est exposé dans l'évidement central (13) de la plaque conductrice (12) et que le point de contact (30, 32) de l'élément porteur (11) est exposé dans l'évidement de contact (34, 36) de la plaque conductrice (12),
- un corps de logement (14) est fourni, qui présente un évidement central (26) et sur la face intérieure duquel au moins un élément de contact (46, 48) conducteur électrique est disposé,
- le corps de logement (14) est couplé physiquement à la plaque conductrice (12) de sorte que le sous-ensemble optoélectronique (15) est exposé dans l'évidement central (26) du corps de logement (14), et l'élément de contact (46, 48) couple électriquement le point de contact (30, 32) de l'élément porteur (11) au point de raccordement (38, 40) de la plaque conductrice (12).

16. Procédé selon la revendication 15, dans lequel l'élément de contact (46, 48) est fixé au corps de logement (14) au moyen d'une tige de fixation (50) du corps de logement (14) et d'un évidement de retenue (50) correspondant de l'élément de contact (46, 48).
